(19) Europäisches Patentamt
European Patent Office
Office européen des brevets

(11) **EP 2 434 533 B1**

(12) **FASCICULE DE BREVET EUROPEEN**

(45) Date de publication et mention
de la délivrance du brevet:
**01.01.2020 Bulletin 2020/01**

(51) Int Cl.:
***H01L 21/18*** *(2006.01)*  ***H01L 25/00*** *(2006.01)*
*H01L 21/66* *(2006.01)*  *H01L 23/00* *(2006.01)*

(21) Numéro de dépôt: **11176277.9**

(22) Date de dépôt: **02.08.2011**

(54) **PROCÉDÉ DE COLLAGE PAR ADHÉSION MOLÉCULAIRE AVEC RÉDUCTION DE DÉSALIGNEMENT DE TYPE OVERLAY**

MOLEKULARE VERBINDUNG MIT REDUZIERTEN OVERLAY FEHLAUSRICHTUNG

BONDING PROCESS BY MOLECULAR BONDING WITH REDUCED OVERLAY TYPE MISALIGNMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.09.2010 FR 1057647**

(43) Date de publication de la demande:
**28.03.2012 Bulletin 2012/13**

(73) Titulaire: **Soitec**
**38190 Bernin (FR)**

(72) Inventeurs:
• **Gaudin, Gweltaz**
**38000 GRENOBLE (FR)**

• **Broekaart, Marcel**
**38570 THEYS (FR)**
• **Castex, Arnaud**
**38100 GRENOBLE (FR)**

(74) Mandataire: **IP Trust**
**2, rue de Clichy**
**75009 Paris (FR)**

(56) Documents cités:
EP-A1- 0 410 679  WO-A1-2010/102943
FR-A1- 2 848 337  US-A- 5 273 553
US-A1- 2006 024 917

**Description**

Domaine technique et art antérieur

La présente invention concerne le domaine des plaques ou structures semi-conducteurs multicouches (également dénommées "multilayer semiconductor wafers") réalisées suivant la technologie d'intégration tridimensionnelle (3D-integration) qui met en œuvre le transfert sur une première plaque, dite substrat final, d'au moins une couche formée à partir d'une deuxième plaque, cette couche correspondant à la portion de la deuxième plaque dans laquelle on a formé des éléments, par exemple, une pluralité de microcomposants, la première plaque pouvant être vierge ou comporter d'autres éléments correspondants.

En raison notamment de la taille très réduite et du nombre important de microcomposants présents sur une même couche, chaque couche transférée, c'est-à-dire chaque plaque comportant la couche, doit être positionnée sur le substrat final (première plaque seule ou comportant déjà d'autres couches transférées) avec une précision correcte afin de respecter une tolérance d'alignement de l'ordre de 0.3 microns avec la couche sous-jacente. En outre, il peut être nécessaire de réaliser des traitements sur la couche après son transfert, par exemple pour former d'autres microcomposants, pour découvrir en surface des microcomposants, pour réaliser des interconnections, etc., ces traitements devant également être réalisés avec une grande précision vis-à-vis des composants présents dans la couche.

Les éléments, tels que des microcomposants, sont formés typiquement par la technique bien connue de photolithographie qui consiste principalement à irradier un substrat rendu photosensible (par exemple par application d'une photorésine sur le substrat) sur des zones déterminées correspondant aux emplacements où les microcomposants doivent être formés. L'irradiation du substrat est réalisée typiquement avec un appareil d'irradiation sélective, couramment appelé "stepper", qui, à la différence des appareils d'irradiation globale, irradie lors d'une opération seulement une partie du substrat à travers un masque formé de zones opaques et transparentes permettant de définir le motif que l'on souhaite reproduire sur le substrat. L'outil d'irradiation ou stepper répète l'opération d'irradiation à autant d'endroits que nécessaire pour irradier l'ensemble de la surface du substrat.

Le transfert d'une couche sur le substrat final implique un collage, par exemple par adhésion moléculaire, entre une première plaque et une deuxième plaque du type de celles décrites ci-avant, la deuxième plaque étant en général ensuite amincie. Lors du collage, les deux plaques sont mécaniquement alignées. Au moins trois types principaux de déformations conduisant à des défauts d'alignement peuvent être constatés entre les deux plaques, à savoir les déformations de type décalage (encore appelé "offset" ou "shift"), de type rotation et de type radial (également connu sous le nom de "run-out" et qui correspond à une dilatation radiale qui augmente linéairement avec le rayon du substrat).

Le stepper est en général apte à compenser ces types de défauts en utilisant un algorithme de compensation.

Cependant, la déposante a constaté, qu'après transfert, il existe des cas où il est très difficile, voire impossible, de former des microcomposants supplémentaires en alignement par rapport aux microcomposants formés avant le transfert en respectant les critères exigés par la technologie des microcomposants, et ce malgré l'utilisation d'algorithmes de compensation.

En outre des défauts d'alignement de type décalage, rotation et radial décrits ci-avant, des déformations inhomogènes peuvent en effet survenir dans la couche transférée en raison de son collage par adhésion moléculaire, ainsi que dans la première plaque.

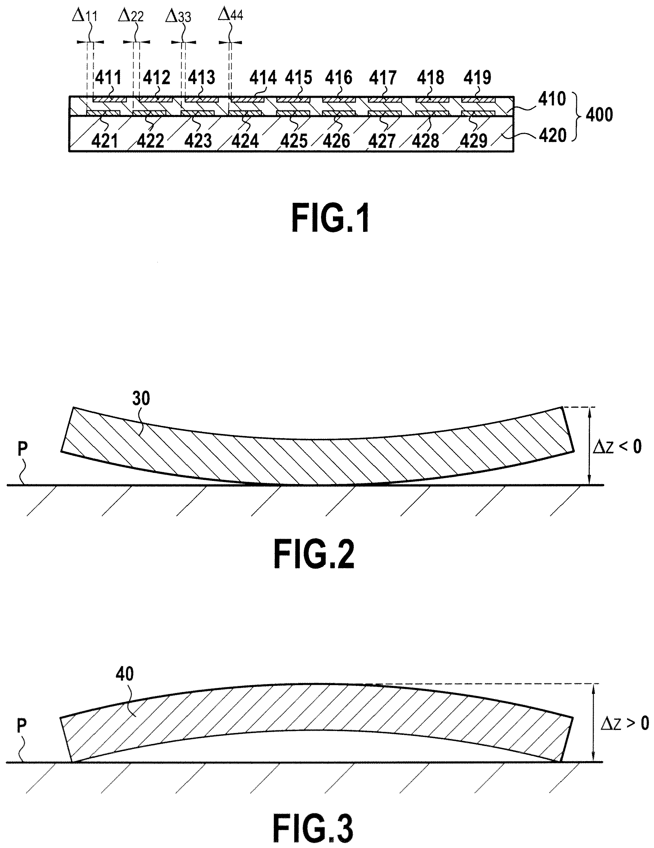

Or ce sont ces déformations inhomogènes des plaques qui engendrent ensuite ce phénomène de désalignement, encore appelé « overlay », qui est décrit en relation avec la figure 1. L'overlay se présente sous la forme de défauts de l'ordre de 50 nm, nettement inférieure à la précision d'alignement des plaques au moment du collage.

La figure 1 illustre une structure tridimensionnelle 400 obtenue par collage par adhésion moléculaire à basse pression entre une première plaque ou substrat initial 410, sur lequel est formée une première série de microcomposants 411 à 419 par photolithographie au moyen d'un masque permettant de définir les zones de formation de motifs correspondant aux microcomposants à réaliser, et une deuxième plaque ou substrat final 420. Le substrat initial 410 a été aminci après collage afin de retirer une portion de matière présente au-dessus de la couche de microcomposants 411 à 419 et une deuxième couche de microcomposants 421 à 429 a été formée au niveau de la surface exposée du substrat initial 410.

Cependant, même en utilisant des outils de positionnement, des décalages se produisent entre certains des microcomposants 411 à 419, d'une part et 421 à 429, d'autre part, tels que les décalages $\Delta_{11}$, $\Delta_{22}$, $\Delta_{33}$, $\Delta_{44}$, indiqués sur la figure 1 (correspondant respectivement aux décalages observés entre les couples de microcomposants 411/421, 412/422, 413/423 et 414/424).

Ces décalages ne résultent pas de transformations élémentaires (translation, rotation ou leurs combinaisons) qui pourraient avoir pour origine un assemblage imprécis des substrats. Ces décalages résultent de déformations inhomogènes qui apparaissent dans la couche provenant du substrat initial lors de son collage avec le substrat final. En fait, ces déformations entraînent des déplacements locaux et non uniformes au niveau de certains microcomposants 411 à 419. Aussi, certains des microcomposants 421 à 429 formés sur la surface exposée du substrat après transfert présentent des variations de position avec ces microcomposants 411 à 419 qui peuvent être de l'ordre de plusieurs centaines de nanomètres, voire du micron. Ce phénomène de désalignement, encore appelé "overlay", peut rendre impossible l'utilisation du stepper si l'amplitude de l'overlay après correction est encore comprise, par exemple entre 50 nm et 100 nm en fonction de l'application. Il est alors très difficile, voire impossible, de former des microcomposants supplémentaires en alignement avec les microcomposants formés avant le transfert.

Ce phénomène d'overlay entre les deux couches de microcomposants peut être en outre source de courts-circuits, de distorsions dans l'empilement ou de défauts de connexion entre les microcomposants des deux couches. Ainsi, dans le cas où les microcomposants transférés sont des imageurs formés de pixels et que les étapes de traitement post transfert visent à former sur chacun de ces pixels des filtres de couleur, on a observé une perte de la fonction de colorisation pour certains de ces pixels.

Par conséquent, s'il n'est pas contrôlé, ce phénomène de désalignement ou overlay conduit ainsi à une réduction de la qualité et de la valeur des plaques de semi-conducteurs multicouches fabriquées. L'impact de ce phénomène devient de plus en plus critique en raison des exigences sans cesse croissantes vis-à-vis de la miniaturisation des microcomposants et de leur densité d'intégration par couche.

Le document WO 2010/102943 A1 propose une solution pour réduire le phénomène d'overlay entre les microcomposants formés sur une face d'un premier substrat et ceux formés sur l'autre face après transfert sur un second substrat.

Résumé de l'invention

L'invention a pour but de proposer une solution qui permet de réduire l'apparition du phénomène d'overlay après collage de deux plaques par adhésion moléculaire.

A cet effet, la présente invention propose un procédé de collage par adhésion moléculaire d'une première plaque présentant une courbure propre avant collage sur une deuxième plaque présentant une courbure propre avant collage, au moins l'une des deux plaques comportant au moins une série de microcomposants, le procédé comprenant au moins une étape de mise en contact des deux plaques de manière à initier la propagation d'une onde de collage entre les deux plaques, caractérisé en ce que, lors de l'étape de mise en contact, on impose à l'une des deux plaques une courbure de collage prédéfinie en forme de paraboloïde de révolution au moins en fonction de la courbure propre avant collage de la plaque comportant une série de microcomposants, l'autre plaque étant libre de se conformer à ladite courbure de collage prédéfinie.

Le procédé comprend, lors de l'étape de mise en contact, les étapes suivantes:

- le maintien de la première plaque et de la deuxième plaque en regard l'une de l'autre par respectivement un premier support de maintien et un second support de maintien, le premier support imposant à la première plaque la courbure de collage prédéfinie en forme de paraboloïde de révolution qui est fonction des courbures propres avant collage des première et deuxième plaques,
- la mise en contact desdites plaques pour initier la propagation d'une onde de collage entre lesdites plaques,
- la libération de la deuxième plaque du second support de maintien avant ou pendant la mise en contact avec la première plaque de manière à ce que la deuxième plaque se conforme à la courbure de collage prédéfinie en forme de paraboloïde de révolution imposée à la première plaque lors de la propagation de l'onde de collage.

Comme expliqué ci-après en détails, en contrôlant la courbure des plaques pendant leur collage en fonction de la courbure propre de la couche comportant les microcomposants et suivant une forme en forme de paraboloïde de révolution, il est possible de contrôler les déformations induites dans cette plaque pendant et après le collage de manière à ce que ces dernières soit essentiellement de type radial, c'est-à-dire des déformations homogènes aptes à être corrigées par les algorithmes utilisés par les appareils de type stepper lors de la réalisation de microcomposants.

Selon un aspect de l'invention, avant le collage des plaques, le procédé comprend les étapes suivantes:

- mesure de la courbure de chaque plaque avant collage,
- calcul de la courbure de collage prédéfinie.

Selon un autre aspect de l'invention, lorsque seule la première plaque comporte au moins une série de microcomposants, la courbure de collage prédéfinie en forme de paraboloïde de révolution est calculée avec la formule suivante:

$$K_B = K_1 - ((K_2 - K_1)/6)$$

où $K_B$ est la courbure de collage prédéfinie en forme de paraboloïde de révolution, $K_1$ la courbure propre de la première plaque avant collage et $K_2$ la courbure propre de la deuxième plaque avant collage.

Selon encore un autre aspect de l'invention, lorsque chacune des deux plaques comporte au moins une série de microcomposants, la courbure de collage prédéfinie en forme de paraboloïde de révolution est calculée avec la formule suivante:

$$K_B = (K_1 + K_2)/2$$

où $K_B$ est la courbure de collage prédéfinie en forme de paraboloïde de révolution, $K_1$ la courbure propre de la première plaque avant collage et $K_2$ la courbure propre de la deuxième plaque avant collage.

Les première et deuxième plaques peuvent notamment être des plaquettes de silicium ayant un diamètre de 300 mm.

Selon un mode particulier de réalisation de l'invention, la courbure de collage prédéfinie en forme de paraboloïde de révolution est imposée à la première plaque par actionnement d'un vérin monté sur le premier support de maintien.

Selon un autre mode particulier de réalisation de l'invention, la courbure de collage prédéfinie en forme de paraboloïde de révolution est imposée à la première plaque par une membrane interposée entre la première plaque et le premier support de maintien, ladite membrane présentant une courbure en forme de paraboloïde de révolution correspondant à la courbure de collage prédéfinie en forme de paraboloïde de révolution.

Selon encore un autre mode particulier de réalisation de l'invention, la courbure de collage prédéfinie en forme de paraboloïde de révolution est imposée à la première plaque par le premier support de maintien, le premier support de maintien présentant une courbure en forme de paraboloïde de révolution correspondant à la courbure de collage prédéfinie en forme de paraboloïde de révolution.

Selon un aspect particulier de l'invention, les plaques comprennent chacune des microcomposants sur leur face de collage respective, au moins une partie des microcomposants d'une des plaques étant destinée à être alignée avec au moins une partie des microcomposants de l'autre plaque.

La présente invention a également pour objet un appareil de collage par adhésion moléculaire d'une première plaque présentant une courbure propre avant collage sur une deuxième plaque présentant une courbure propre avant collage, au moins l'une des deux plaques comportant au moins une série de microcomposants, l'appareil comprenant des premier et second supports de maintien pour maintenir respectivement la première plaque et la deuxième plaque, caractérisé en ce que ledit premier support de maintien comprend des moyens pour imposer à la première plaque une courbure de collage prédéfinie en forme de paraboloïde de révolution au moins en fonction de la courbure propre avant collage de la plaque comprenant la couche de microcomposants, l'appareil commandant le deuxième support de maintien pour libérer la deuxième plaque du deuxième support avant ou pendant la mise en contact avec la première plaque de manière à ce que ladite deuxième plaque se conforme à la courbure de collage prédéfinie en forme de paraboloïde de révolution imposée à la première plaque lors de la propagation d'une onde de collage.

Selon un aspect de l'invention, l'appareil comprend des moyens de traitement pour calculer la courbure de collage prédéfinie en forme de paraboloïde de révolution en fonction de la courbure propre avant collage de chacune des deux plaques ou un rayon de courbure correspondant à la courbure de collage prédéfinie en forme de paraboloïde de révolution. Toutefois ces moyens peuvent malgré tout être déportés par rapport à l'appareil de collage. Autrement dit, le procédé peut fonctionner aussi si les moyens de traitement sont dissociés de l'appareil de collage.

Selon un mode particulier de réalisation de l'invention, le premier support de maintien comprend en outre un vérin apte à imposer la courbure de collage prédéfinie en forme de paraboloïde de révolution à la première plaque, le vérin étant piloté selon un rayon de courbure correspondant à ladite courbure de collage prédéfinie en forme de paraboloïde de révolution, l'appareil commandant le deuxième support de maintien pour libérer la deuxième plaque du second support après mise en contact avec la première plaque de manière à ce que ladite deuxième plaque se conforme à la courbure de collage prédéfinie en forme de paraboloïde de révolution imposée à la première plaque lors de la propagation d'une onde de collage.

Selon un autre mode particulier de réalisation de l'invention, le premier support de maintien présente une courbure correspondant à la courbure de collage prédéfinie en forme de paraboloïde de révolution ou en ce que l'appareil de collage comprend en outre une membrane interposée entre la première plaque et le premier support de maintien, ladite membrane présentant une courbure correspondant à la courbure de collage prédéfinie en forme de paraboloïde de révolution.

Selon un autre aspect de l'invention, les premier et deuxième supports de maintien sont adaptés pour recevoir des substrats circulaires de 100 mm, 150 mm, 200 mm ou 300 mm de diamètre.

Brève description des figures

- la figure 1 est une vue schématique en coupe montrant des défauts d'alignement de type overlay entre des microcomposants de deux plaques après collage de celle-ci par adhésion moléculaire selon l'art antérieur,
- les figures 2 et 3 montrent des plaques présentant des déformations de type "bow",
- les figures 4A à 4C montrent les différentes courbures obtenues avant, pendant et après le collage de deux plaques par adhésion moléculaire,
- les figures 5A à 5F, sont des vues schématiques montrant la réalisation d'une structure tridimensionnelle mettant en oeuvre le procédé de collage par adhésion moléculaire conformément à un mode de réalisation de la présente invention,
- la figure 6 est un organigramme des étapes mises en œuvre lors de la réalisation de la structure tridimensionnelle illustrée dans les figures 5A à 5G,

- les figures 7A à 7G, sont des vues schématiques montrant la réalisation d'une structure tridimensionnelle mettant en œuvre le procédé de collage par adhésion moléculaire conformément à un autre mode de réalisation de la présente invention,

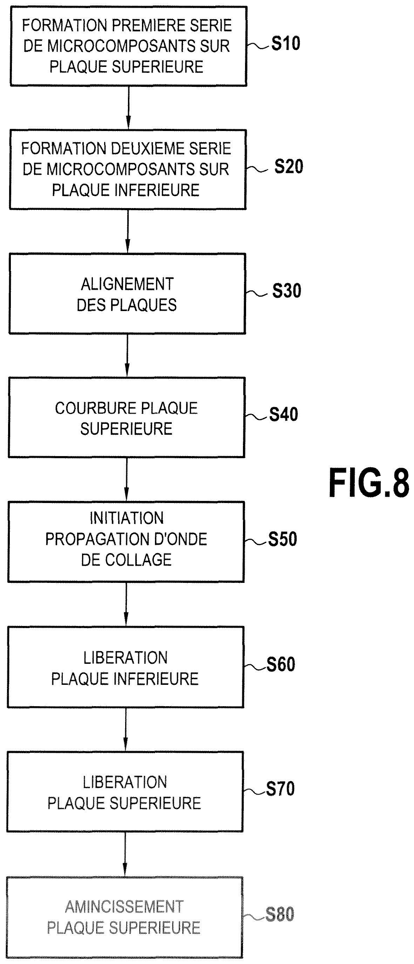

- la figure 8 est un organigramme des étapes mises en œuvre lors de la réalisation de la structure tridimensionnelle illustrée dans les figures 7A à 7G.

Exposé détaillé de modes de réalisation de l'invention

L'invention s'applique au collage par adhésion moléculaire entre deux plaques, au moins une de ces deux plaques comprenant des microcomposants ayant été réalisés avant le collage. Par souci de simplification, on appellera "microcomposants" dans la suite de ce texte, les dispositifs ou tout autres motifs résultant des étapes technologiques réalisées sur ou dans les couches et dont le positionnement doit être contrôlé avec précision. Il peut donc s'agir de composants actifs ou passifs, de simples motifs, de prises de contact ou d'interconnexions.

Afin de réduire l'apparition du phénomène d'overlay décrit précédemment, la présente invention propose de réduire les déformations inhomogènes des plaques résultant de leur collage, en imposant auxdites plaques pendant collage une courbure de collage qui a été définie préalablement en fonction de la courbure initiale de la ou des plaques comprenant les microcomposants.

Avant leur collage, chaque plaque présente une courbure propre qui peut être concave comme pour la plaque 30 de la figure 2 ou convexe comme pour la plaque 40 de la figure 3. Cette courbure détermine la déformation de courbure des plaques qui est désignée par le terme anglais "bow" dans la technologie de semi-conducteurs. Comme illustré sur les figures 2 et 3, le bow $\Delta z$ d'une plaque ou wafer correspond à la distance (flèche), généralement mesurée au niveau du centre de la plaque, entre un plan de référence P (typiquement parfaitement plat) sur lequel repose librement la plaque et la plaque elle-même. A l'échelle des diamètres de plaques habituellement utilisées dans le domaine des semiconducteur, à savoir entre quelques dizaines de millimètres et 300 millimètres, le bow est mesuré en micromètres tandis que la courbure est généralement mesurée en $m^{-1}$ ou $km^{-1}$ car la courbure des plaques utilisées dans le domaine des semi-conducteurs est très faible et, par conséquent, le rayon de courbure correspondant très important.

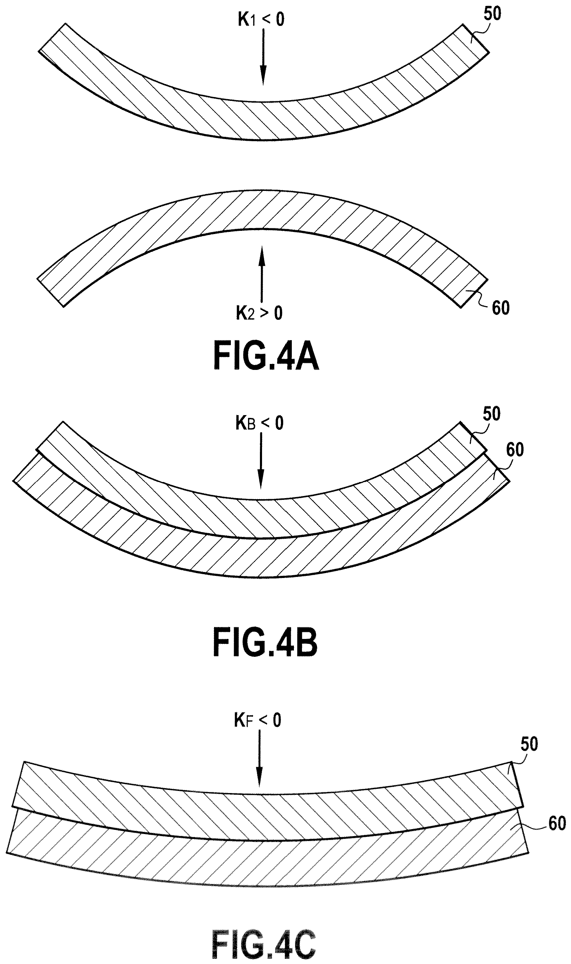

Les figures 4A à 4C montrent l'évolution des courbures avant et après collage d'une première plaque 50 (Top) sur une plaque support 60 (Base) présentant respectivement des courbures initiales $K_1$ et $K_2$, c'est-à-dire des courbures propres avant collage (figure 4A). Lors du collage par adhésion moléculaire, une courbure $K_B$, dite courbure de collage, est imposée à l'une des deux plaques 50 et 60 (figure 4B), l'autre plaque venant se conformer à la courbure imposée à cette première plaque lors de la propagation de l'onde de collage comme décrit en détails ci-après. La courbure $K_B$ peut être imposée par des supports de maintien spécifiques d'une machine de collage comme décrit ci-après en détails, la courbure $K_B$ étant imposée à une seule des deux plaques tandis que l'autre plaque est libre de se déformer au moment de l'initiation de la propagation de l'onde de collage afin de se conformer, lors de cette propagation, à la courbure imposée à l'autre plaque.

Une fois le collage réalisé et les plaques libérées de leur support de maintien respectifs, la structure constituée par l'assemblage des plaques collées 50 et 60 présente une courbure $K_F$, dite courbure post collage.

La courbure post collage $K_F$ peut être calculée avec la formule suivante:

$$K_F = (2(K_1 + K_2) + 12K_B)/16 \qquad (1)$$

Cette formule a été déterminée à partir de la formule (12) donnée dans le document T. Turner et al., intitulé "Mechanics of wafer bonding: Effect of clamping", Journal of Applied Physics, Vol. 95, N° 1, January 1, 2004.

Comme expliqué ci-avant, lors du collage par adhésion moléculaire entre deux plaques dont au moins l'une d'entre elles comporte des microcomposants, des déformations inhomogènes peuvent survenir dans la plaque comportant les microcomposants, ces déformations ne pouvant pas être compensées par les algorithmes de compensation des appareils de type stepper lors de la formation de microcomposants supplémentaires après collage, ce qui conduit à des décalages indésirables entre les microcomposants formés avant et après collage ("overlay").

En revanche, si après collage, la plaque comportant les microcomposants ne présente quasiment que des déformations de type radial, c'est-à-dire des déformations homogènes, celles-ci peuvent être corrigées après collage par des algorithmes.

Par conséquent, la présente invention propose de contrôler la courbure post collage afin que la ou les plaques comportant des microcomposants présentent, après collage, seulement des déformations de type radial qui peuvent être corrigées.

Dans le cas d'un collage entre une première plaque dans ou sur laquelle des microcomposants ont été préalablement formés et présentant une courbure propre $K_1$ avec une deuxième plaque sans microcomposant et présentant une courbure propre $K_2$, la déposante a démontré que pour obtenir seulement des déformations radiales dans la première plaque, la déformation de la première plaque doit être minimale et la courbure post collage $K_F$ doit être en forme de paraboloïde de révolution. A cet effet, les plaques présentent une courbure initiale au moins approximativement en forme de paraboloïde de révolution (en particulier de forme sphérique qui est un cas particulier de paraboloïde de révolution) qui permet d'obtenir une courbure post collage de forme similaire après imposition d'une courbure de collage en forme de paraboloïde de révolution.

De façon bien connue en soi, l'équation des coordonnées cartésiennes d'un paraboloïde de révolution s'écrit de la façon suivante:

$$x^2 + y^2 = 2pz \qquad (2)$$

Avec x, y et z étant les coordonnées cartésiennes du paraboloïde de révolution et p une constante.

L'équation cylindrique d'un paraboloïde de révolution s'écrit de la façon suivante:

$$\rho^2 = 2pz \qquad (3)$$

avec $\rho$ la coordonnée cylindrique du paraboloïde de révolution (telle que $\rho = x^2 + y^2$).

La courbure totale $K_P$ d'un paraboloïde de révolution peut être calculée avec la formule suivante:

$$K_P = p^2/(\rho^2 + p^2) \qquad (4)$$

La déformation minimale de la première plaque comportant les microcomposants est obtenue en visant $K_F = K_1$. Si l'on reporte cette condition dans l'équation (1), une déformation minimale de la première est obtenue en imposant une courbure de collage en forme de paraboloïde de révolution $K_B$ telle que:

$$K_B = K_1 - ((K_2 - K_1)/6) \qquad (5)$$

Dans le cas d'un collage entre une première plaque et une deuxième plaque comportant chacune des microcomposants formés avant collage et présentant respectivement une courbure propre $K_1$, $K_2$, les déformations des première et deuxième plaques doivent être minimales et la courbure post collage $K_F$ doit être en forme de paraboloïde de révolution.

La déformation minimale des première et deuxième plaques comportant les microcomposants est obtenue en visant $K_F = (K_1 + K_2)/2$. Si l'on reporte cette condition dans l'équation (1), une déformation minimale de la première est obtenue en imposant une courbure de collage en forme de paraboloïde de révolution $K_B$ telle que:

$$K_B = (K_1 + K_2)/2 \qquad (6)$$

Ainsi, il est possible de déterminer la courbure en forme de paraboloïde de révolution $K_B$ à imposer aux plaques lors du collage à partir des formules (5) ou (6).

suivant respectivement que l'une ou les deux plaques comportent des microcomposants, afin d'obtenir la courbure post collage $K_F$ qui permet de contrôler les déformations dans la ou les plaques comportant les microcomposants pour que ces déformations soient de type radial, c'est-à-dire homogènes et compensables par un algorithme de correction. Les courbures $K_1$ et $K_2$ sont mesurées préalablement, par exemple au moyen d'outils de mesure optique tels que KLA-Tencor Flexus de la société KLA-Tencor Corp (ou par toute mesure par jauge capacitive, profilométrie optique ou mécanique qui permet de déterminer le bow).

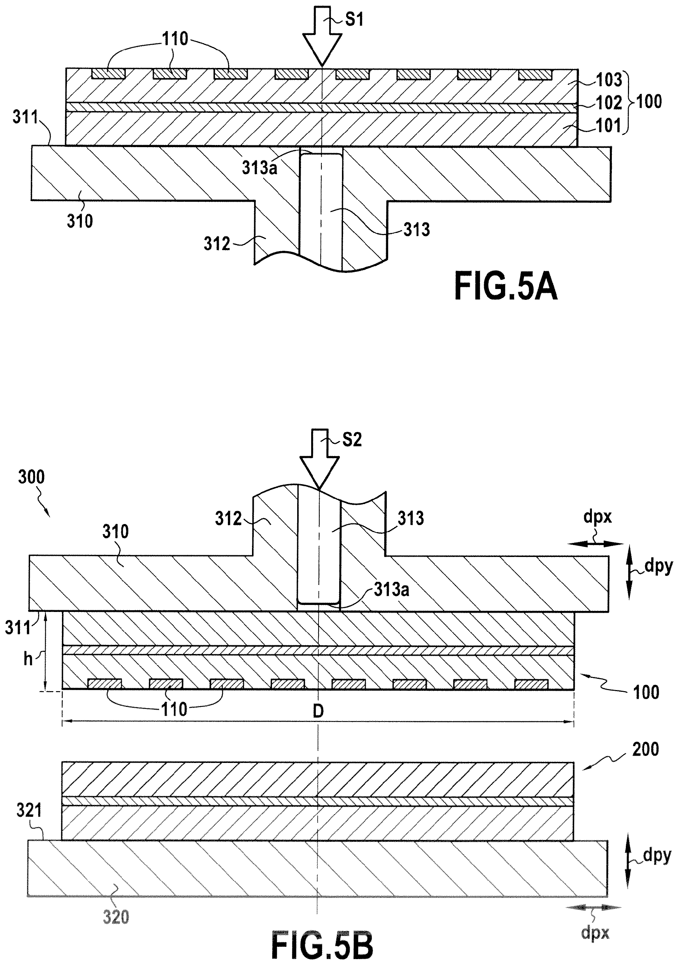

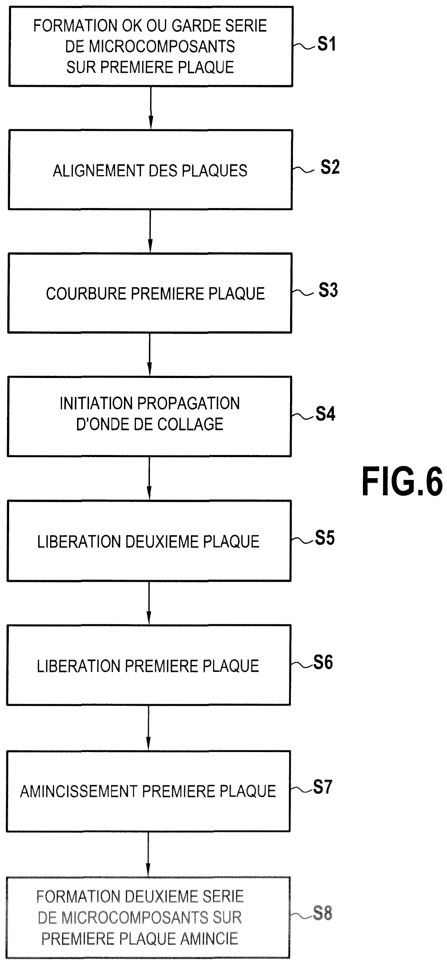

On décrit maintenant en relation avec les figure 5A à 5F et 6 un exemple de réalisation d'une structure tridimensionnelle par transfert d'une couche de microcomposants formée sur une première plaque 100 sur une deuxième plaque 200 mettant en œuvre un procédé de collage avec réduction du désalignement de type overlay conformément à un mode de réalisation de l'invention. Les plaques peuvent notamment avoir des diamètres de 150 mm, 200 mm et 300 mm.

La réalisation de la structure tridimensionnelle débute par la formation d'une première série de microcomposants 110 à la surface de la première plaque 100 (figure 5A, étape S1). Les microcomposants 110 peuvent être des composants entiers et/ou seulement une partie de ceux-ci. Dans l'exemple décrit ici, la première plaque 100 est une plaque de 300 mm de diamètre de type SOI (Silicium sur Isolant) comprenant une couche de silicium 103 sur un support 101 également en silicium, une couche d'oxyde enterrée 102, par exemple en $SiO_2$, étant disposée entre la couche et le support en silicium. La plaque 100 peut être également constituée d'une structure multicouche d'un autre type ou d'une structure monocouche.

La deuxième plaque 200 est une plaque en silicium de 300 mm de diamètre (figure 5B).

Les microcomposants 110 sont formés par photolithographie au moyen d'un masque permettant de définir les zones de formation de motifs correspondant aux microcomposants à réaliser, un outil d'irradiation sélective de type stepper étant utilisé pour irradier les zones où les motifs doivent être réalisés.

Les microcomposants 110 sont destinés à coopérer avec des microcomposants qui seront formés ultérieurement au collage sur la couche transférée Il est donc important de pouvoir assurer un bon alignement des microcomposants 110 et 210 après collage des plaques.

Conformément à l'invention, on utilise une machine de collage qui, lors du collage, impose une courbure de collage en forme de paraboloïde de révolution $K_B$ à l'une des plaques tout en permettant à l'autre plaque de se conformer à la courbure imposée par propagation de l'onde de collage entre les deux plaques. Cette opération permet d'obtenir une courbure post collage paraboloïdale cible $K_{Fc}$ qui permet de contrôler la déformation de la première plaque 100 de manière à ce que cette dernière présente seulement des déformations radiales, c'est-à-dire homogènes conduisant à des désalignement qui peuvent être corrigés avec un algorithme approprié. Dans l'exemple décrit ici, les plaques 100 et 200 présentent respectivement des courbures $K_1$ et $K_2$ de forme paraboloïdale. Par conséquent, on impose ici aux plaques une courbure de collage prédéfinie $K_B$ de forme paraboloïdale.

Comme illustré sur la figure 5B, l'opération de collage est réalisée avec une machine ou appareil de collage 300 qui comprend un premier plateau support 310 présentant une surface de maintien 311 destinée à maintenir la première plaque 100 en regard de la deuxième plaque 200 qui est maintenue sur la surface de maintien 321 d'un deuxième plateau support 320 de la machine 300. Les plateaux supports 310 et 320 sont tous les deux équipés de moyens de maintien (non représentés sur la figure 5B), tels des moyens de maintien électrostatiques ou par succion. Les premier et second plateaux supports 310 et 320 sont chacun mobiles suivant des directions de déplacement $d_{px}$ et $d_{py}$ qui permettent, d'une part, de positionner les plaques l'une en face de l'autre en compensant les erreurs de désalignement en rotation et en translation et, d'autre part, de rapprocher ou d'écarter les surfaces de maintien 311 et 321 respectivement des premier et second plateaux supports 310 et 320. A cet effet, chaque plateau support est, par exemple, monté sur un actionneur (non représenté sur la figure 5B) qui est commandé par la machine de collage afin d'ajuster la distance entre les deux supports suivant la direction $d_P$.

Au début du collage, les deux plaques 100 et 200 sont chacune maintenues plaquées sur les surfaces de maintien de leur plateau support respectif (figure 5B, étape S2).

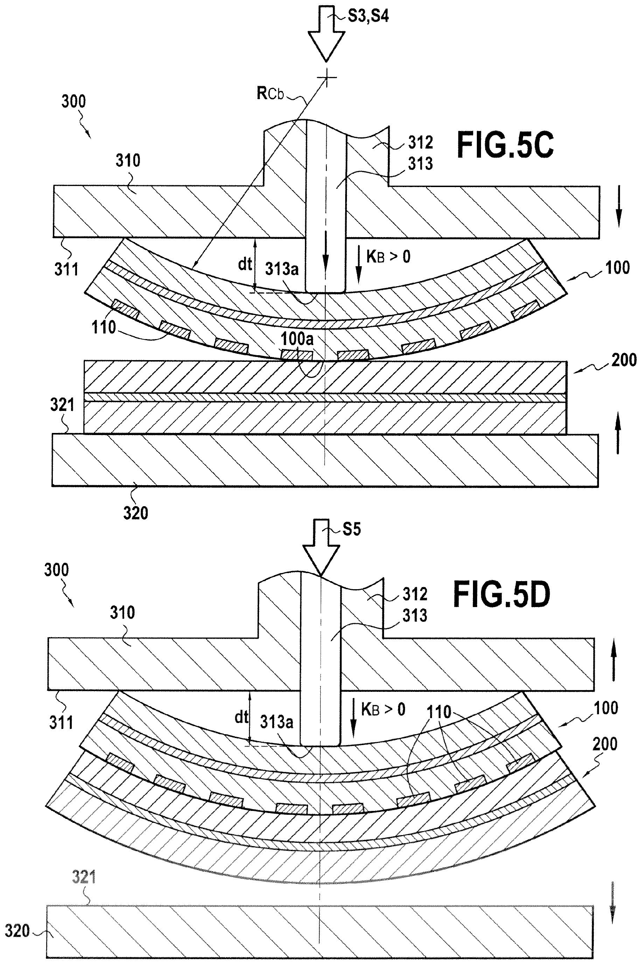

Ensuite, conformément à l'invention, on impose à la première plaque 100 (ou alternativement à la deuxième plaque) une courbure correspondant à la courbure de collage paraboloïdale $K_B$ qui a été calculée au moyen de la formule (5) donnée plus haut et qui permet d'obtenir la courbure post collage paraboloïdale cible $K_F$ déterminée préalablement afin d'induire dans la première plaque des déformations essentiellement du type radial (figure 5C, étape S3).

A cet effet, le premier plateau support 310 comprend un vérin ou actionneur linéaire 312 muni d'une tige 313 qui, lorsque le vérin est actionné, s'étend au-delà de la surface de maintien 311 du plateau 310 sur laquelle est plaquée la première plaque 100. Comme illustré sur la figure 5C, dans ce cas, l'extrémité libre 313a de la tige 313 pousse sur la première plaque, ce qui permet d'imposer à cette dernière une courbure de collage paraboloïdale déterminée. Lors de l'actionnement du vérin 312, la force d'attraction des moyens de maintien du plateau support 310, à savoir la force de succion ou la force électrostatique, peut être contrôlée par la machine de collage de manière à être diminuée, voire annulée, au niveau d'une zone centrale concentrique délimitée sur la surface de maintien 311 du plateau 310 de manière à réduire les contraintes sur la plaque lors de sa courbure par la tige 313.

La machine de collage 300 contrôle la distance dt sur laquelle la tige 313 se projette au-delà de la surface de maintien 311, cette distance dt étant déterminée en fonction de la courbure de collage $K_B$ à imposer aux plaques. Plus précisément, le vérin 312 est équipé d'une servocommande (non représentée) qui contrôle la position linéaire de la tige 313 en fonction d'une position de consigne définie par la machine de collage 300.

La machine de collage 300 est équipée de moyens de traitement, tels qu'un microprocesseur programmable, qui sont aptes à calculer la courbure de collage paraboloïdale $K_B$ ou un rayon de courbure équivalent à la courbure de collage paraboloïdale $K_B$ dans le cas de l'utilisation d'un vérin comme dans la machine 300 décrite ici. Plus précisément, les courbures initiales $K_1$ et $K_2$ respectivement des plaques 100 et 200 ainsi que la courbure post collage cible paraboloïdale $K_F$ sont entrées dans la machine de collage, les moyens de traitement de la machine de collage calculant alors la courbure de collage paraboloïdale $K_B$ à imposer en utilisant la formule (5) donnée ci-avant et inverse cette valeur pour obtenir le rayon de courbure cible correspondant $R_{cb}$ ($R_{cb}=1/K_B$).

Le paramètre final à définir qui doit être envoyé à la servocommande du vérin 312 est le bow $\Delta z$ correspondant au rayon de courbure $R_{cb}$ car, comme indiqué précédemment, le bow d'une plaque ou wafer correspond à la distance, prise au centre de la plaque, entre un plan de référence, ici la surface de maintien 311 et la surface de la plaque, ici la surface de la plaque en regard de la surface de maintien 311. Le bow $\Delta z$ correspond à la distance dt sur laquelle doit s'étendre la tige 313 lors de l'imposition de la courbure de collage.

Le calcul du bow cible $\Delta zc$ en fonction du rayon de courbure cible $R_{cb}$ peut être calculé avec la formule suivante:

$$\Delta zc = R_{cb} - \sqrt{(R_{cb}^2 - (D/2)^2)} \qquad (7)$$

Où D est le diamètre de la plaque à courber.

Une fois calculée, la valeur numérique du bow cible $\Delta zc$ est transmise à la servocommande du vérin 312 qui actionne la tige pour la positionner à la distance $d_t$ équivalente ($d_t = \Delta zc$).

Afin d'imposer une courbure de collage paraboloïdale aux plaques pendant le collage, la tige 313 du vérin 312 est placée au centre de la plaque 100.

Lorsque la courbure de collage paraboloïdale $K_B$ est appliquée à la première plaque 100, on rapproche les plateaux supports 310 et 320 l'un de l'autre afin que la portion la plus avancée 100a (sommet) de la plaque 100 soit délicatement placée en contact avec la surface exposée de la deuxième plaque 200 et initier ainsi la propagation d'une onde de collage (figure 5C, étape S4).

Les moyens de maintien de la deuxième plaque 200 sur son plateau support 320 ont été désactivés avant ou lors de la mise en contact des deux plaques afin de permettre à la deuxième plaque 200 de se conformer à la déformation imposée (courbure $K_B$) à la première plaque 100 lors du collage.

Alternativement, on peut placer les deux plaques à une distance $\Delta zc$ l'une de l'autre et ensuite déformer l'une des deux plaques jusqu'à mettre en contact intime les surfaces par actionnement de la tige 313 sur une distance $d_t = \Delta zc$. On assure ainsi simultanément l'imposition de la courbure de collage paraboloïdale $K_B$ et l'initiation de la propagation de l'onde de collage. Dans ce cas encore, la plaque qui n'est pas déformée à la courbure de collage prédéfinie doit être libre de se conformer à la courbure de collage paraboloïdale à l'autre plaque lors de la propagation de l'onde de collage.

Le collage par adhésion moléculaire est une technique bien connue en soi. Pour rappel, le principe du collage par adhésion moléculaire est basé sur la mise en contact direct de deux surfaces, c'est-à-dire sans l'utilisation d'un matériau spécifique (colle, cire, brasure, etc.). Une telle opération nécessite que les surfaces à coller soient suffisamment lisses, exemptes de particules ou de contamination, et qu'elles soient suffisamment rapprochées pour permettre d'initier un contact, typiquement à une distance inférieure à quelques nanomètres. Dans ce cas, les forces attractives entre les deux surfaces sont assez élevées pour provoquer la propagation d'une onde de collage qui aboutit à l'adhérence moléculaire (collage induit par l'ensemble des forces attractives (forces de Van Der Waals) d'interaction électronique entre atomes ou molécules des deux surfaces à coller).

Une fois la propagation de l'onde collage initiée, la deuxième plaque 200, alors relâchée de son plateau support 320, se conforme à la courbure imposée à la première plaque 100 lors de la progression de l'onde de collage (figure 5D, étape S5).

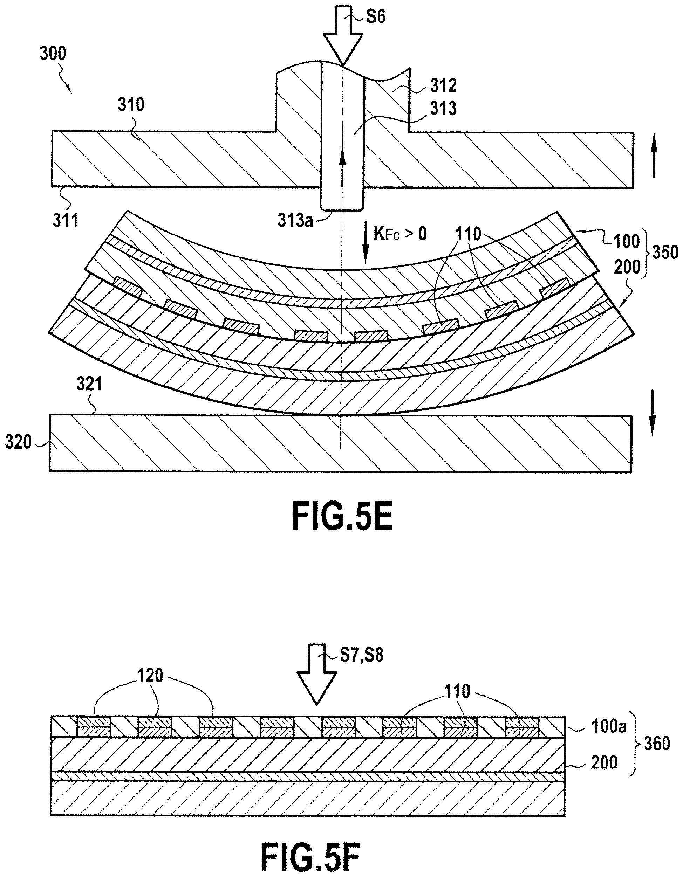

Lorsque les deux plaques sont complètement collées, la première plaque 100 est totalement libérée de son support (figure 5E, étape S6). On obtient alors une structure tridimensionnelle 350 qui présente la courbure paraboloïdale cible $K_F$ définie préalablement. Les déformations inhomogènes apparaissant habituellement lors d'un collage non contrôlé sont ainsi réduites de façon très significative.

Après le collage, la structure 350 peut être soumise à un traitement thermique modéré (inférieur à 500°C) de manière à augmenter l'énergie de collage entre les deux plaques et permettre l'amincissement ultérieur de l'une d'entre elle, le tout sans détériorer les microcomposants 110.

Tel que représentée sur la figure 5F, la première plaque 100 est amincie afin de retirer une portion de matière présente au-dessus de la couche de microcomposants 110 (étape S7). La plaque 100 peut être amincie notamment par polissage mécano-chimique (CMP), par gravure chimique, ou par clivage ou fracture le long d'un plan de fragilisation formé préalablement dans le substrat, par exemple, par implantation atomique. Dans le cas où la première plaque est un substrat de type SOI comme c'est le cas ici, on peut utiliser avantageusement la couche isolante enterrée comme couche d'arrêt de gravure chimique pour délimiter l'épaisseur de la couche 100a restante. Alternativement, si le substrat initial est en matériau massif, des plots profonds, par exemple des plots en matériau métallique régulièrement espacés à la surface du substrat, peuvent être préalablement formés dans celui-ci lors de la formation des composants afin de stopper l'amincissement mécanique (polissage).

On obtient alors une structure tridimensionnelle 360 formée de la deuxième plaque 200 et d'une couche 100a correspondant à la portion restante de la première plaque 100.

Les déformations inhomogènes apparaissant habituellement lors d'un collage non contrôlé sont ainsi réduites de façon très significative. A l'issu du collage, une deuxième série de microcomposants 120 peuvent être formés avec un alignement correct avec les microcomposants 110, les désalignements éventuels entre les microcomposants des première et deuxième séries étant corrigés au moyen d'un algorithme de correction d'alignement (figure 5F, étape S8).

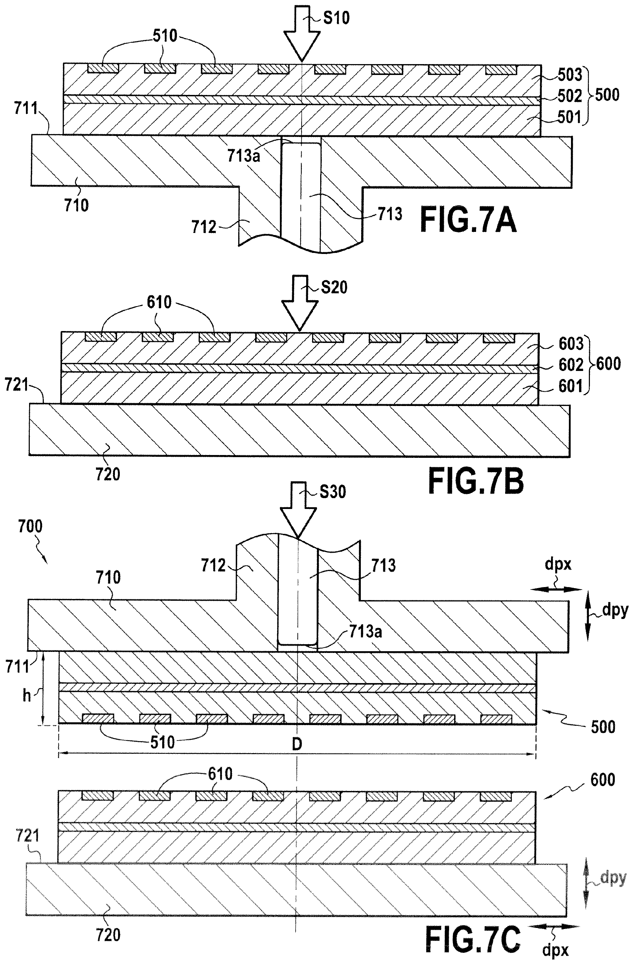

On décrit maintenant en relation avec les figure 7A à 5G et 6 un autre exemple de réalisation d'une structure tridimensionnelle par transfert d'une couche de microcomposants 510 formée sur une première plaque 500 sur une deuxième plaque 600 comportant également une couche de microcomposants 610 mettant en œuvre un procédé de collage avec réduction du désalignement de type overlay conformément à un mode de réalisation de l'invention. Dans cet exemple, les plaques 500 et 600 présentent une courbure initiale en forme de paraboloïde de révolution. Les plaques peuvent notamment avoir des diamètres de 150 mm, 200 mm et 300 mm.

La réalisation de la structure tridimensionnelle débute par la formation d'une première série de microcomposants 510 à la surface de la première plaque 500 (figure 7A, étape S10) et d'une deuxième série de microcomposants 610 à la surface de la deuxième plaque 600 (figure 7B, étape S20). Les microcomposants 510 et 610 peuvent être des composants entiers et/ou seulement une partie de ceux-ci. Dans l'exemple décrit ici, la première plaque 500 est une plaque de 300 mm de diamètre de type SOI (Silicium sur Isolant) comprenant une couche de silicium 503 sur un support 501 également en silicium, une couche d'oxyde enterrée 502, par exemple en $SiO_2$, étant disposée entre la couche et le support en silicium. La plaque 500 peut être également constituée d'une structure multicouche d'un autre type ou d'une structure monocouche.

La deuxième plaque 600 est une plaque en silicium de 300 mm de diamètre.

Les microcomposants 510 et 610 sont formés par photolithographie au moyen d'un masque permettant de définir les zones de formation de motifs correspondant aux microcomposants à réaliser.

Les microcomposants 510 et 610 sont destinés à coopérer entre eux, par exemple pour former des composants finis par la réunion de microcomposants 510 et 610 deux à deux constituant chacun une partie du composant à réaliser ou pour former des circuits par interconnexion de microcomposants 510 et 610 correspondants. Il est donc important de pouvoir assurer un bon alignement entre les microcomposants 510 et 610 pendant le collage des plaques.

Conformément à l'invention, on utilise une machine de collage qui, lors du collage, impose une courbure de collage en forme de paraboloïde de révolution $K_B$ à l'une des plaques tout en permettant à l'autre plaque de se conformer à la courbure imposée par propagation de l'onde de collage entre les deux plaques. Cette opération permet d'obtenir une courbure post collage cible $K_F$ en forme de paraboloïde de révolution qui permet de contrôler la déformation des deux plaques 500 et 600 de manière à ce que ces dernières présentent seulement des déformations radiales, c'est-à-dire homogènes conduisant à des désalignements très faibles entre les composants 510 et 610, et éventuellement à des désalignements (overlay) ultérieurs dans le cas où des composants seraient ultérieurement formés dans la couche 500a restante après amincissement qui peuvent être corrigés avec un algorithme approprié.

Comme illustré sur la figure 7C, l'opération de collage est réalisée avec une machine ou appareil de collage 700 qui comprend, comme la machine 300 décrite ci-avant un premier plateau support 710 présentant une surface de maintien 711 destinée à maintenir la première plaque 500 en regard de la deuxième plaque 600 qui est maintenue sur la surface de maintien 721 d'un deuxième plateau support 720 de la machine 700.

Au début du collage, les deux plaques 500 et 600 sont chacune maintenues plaquées sur les surfaces de maintien de leur plateau support respectif (figure 7C, étape S30).

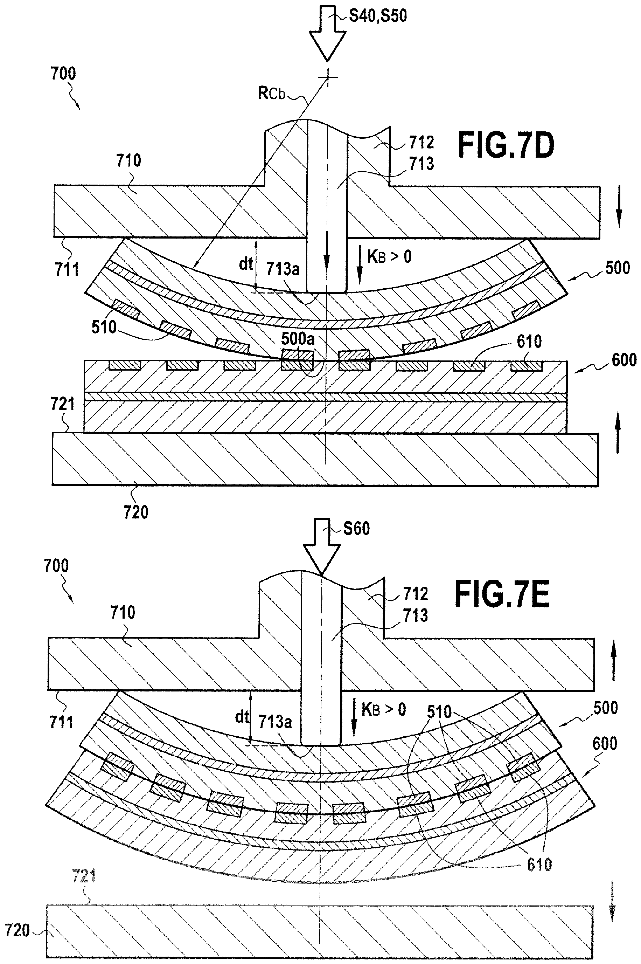

Ensuite, conformément à l'invention, on impose à la première plaque 500 (ou alternativement à la deuxième plaque) une courbure correspondant à la courbure de collage $K_B$ en forme de paraboloïde de révolution qui a été calculée au moyen de la formule (6) donnée plus haut et qui permet d'obtenir la courbure post collage cible $K_F$ en forme de paraboloïde de révolution déterminée préalablement afin d'induire dans les deux plaques des déformations essentiellement du type radial (figure 7D, étape S40).

Comme précédemment décrit pour la machine 300, le premier plateau support 710 comprend un vérin ou actionneur linéaire 712 muni d'une tige 713 qui, lorsque le vérin est actionné, s'étend au-delà de la surface de maintien 711 du plateau 710 sur laquelle est plaquée la première plaque 100. Comme illustré sur la figure 7D, dans ce cas, l'extrémité libre 713a de la tige 713 pousse sur le centre de la première plaque, ce qui permet d'imposer à cette dernière une courbure de collage déterminée en forme de paraboloïde de révolution.

La machine de collage 700 contrôle la distance dt sur laquelle la tige 713 se projette au-delà de la surface de maintien 711. Comme expliqué précédemment, cette distance dt est déterminée par les moyens de traitement de la machine 700 qui, après avoir calculé la courbure de collage $K_B$ en forme de paraboloïde de révolution à imposer en utilisant la formule (6) donnée ci-avant et inversé cette valeur pour obtenir le rayon de courbure cible correspondant Rcb (Rcb=1/KB), détermine le bow cible $\Delta zc$ correspondant à la distance dt sur laquelle doit s'étendre la tige 713 lors de l'imposition de la courbure de collage ($\Delta zc= R_{cb}-\sqrt{(R_{cb}^2-(D/2)^2)}$)

Une fois calculée, la valeur numérique du bow cible $\Delta zc$ est transmise à la servocommande du vérin 712 qui actionne la tige pour la positionner à la distance dt équivalente ($d_t = \Delta zc$).

Lorsque la courbure de collage en forme de paraboloïde de révolution $K_B$ est appliquée à la première plaque 100, on rapproche les plateaux supports 710 et 720 l'un de l'autre afin que la portion la plus avancée 500a (sommet) de la plaque 500 soit délicatement placée en contact avec la surface exposée de la deuxième plaque 600 et initier ainsi la propagation d'une onde de collage (figure 7D, étape S50). Les moyens de maintien de la deuxième plaque 600 sur son plateau support 720 ont été désactivés avant ou lors de la mise en contact des deux plaques afin de permettre à la deuxième plaque 600 de se conformer à la déformation imposée (courbure $K_B$) à la première plaque 500 lors du collage.

Alternativement, on peut placer les deux plaques à une distance $\Delta zc$ l'une de l'autre et ensuite déformer l'une des deux plaques jusqu'à mettre en contact intime les surfaces par actionnement de la tige 713 sur une distance $d_t = \Delta zc$. On assure ainsi simultanément l'imposition de la courbure de collage en forme de paraboloïde de révolution $K_B$ et l'initiation de la propagation de l'onde de collage. Dans ce cas encore, la plaque qui n'est pas déformée à la courbure de collage prédéfinie doit être libre de se conformer à la courbure de collage en forme de paraboloïde de révolution imposée à l'autre plaque lors de la propagation de l'onde de collage.

Une fois la propagation de l'onde de collage initiée, la deuxième plaque 600, alors relâchée de son plateau support 720, se conforme à la courbure imposée à la première plaque 500 lors de la progression de l'onde de collage (figure 7E, étape S60).

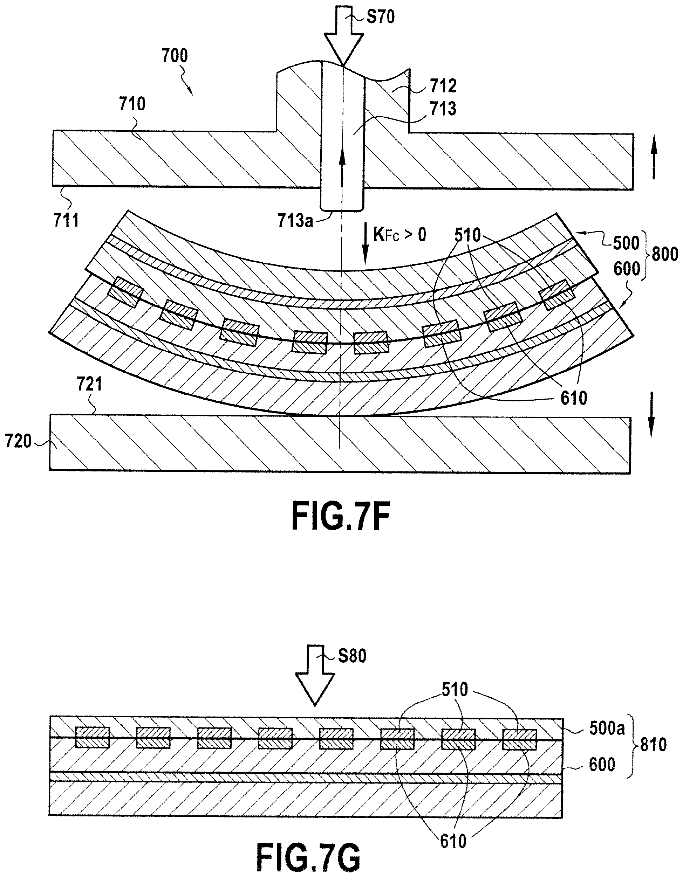

Lorsque les deux plaques sont complètement collées, la première plaque 500 est totalement libérée de son support (figure 7F, étape S70). On obtient alors une structure tridimensionnelle 800 qui présente la courbure cible $K_F$ en forme de paraboloïde de révolution définie préalablement. Les déformations inhomogènes apparaissant habituellement lors d'un collage non contrôlé sont ainsi réduites de façon très significative.

Après le collage, la structure 800 peut être soumise à un traitement thermique modéré (inférieur à 500°C) de manière à augmenter l'énergie de collage entre les deux plaques, permettre l'amincissement ultérieur de l'une d'entre elle, et ne pas détériorer les microcomposants 510 et 610.

Tel que représentée sur la figure 7G, la première plaque 500 est amincie afin de retirer une portion de matière présente au-dessus de la couche de microcomposants 510 (étape S80). On obtient alors une structure tridimensionnelle 810 formée de la deuxième plaque 200 et d'une couche 500a correspondant à la portion restante de la première plaque 500.

Selon une variante de mise en oeuvre, après formation des microcomposants, on peut déposer sur la surface de la première plaque et/ou deuxième plaque une couche d'oxyde, par exemple en $SiO_2$, en vue de la préparation au collage. Cette ou ces couches d'oxyde peuvent être en outre préparées en formant dans ces dernières des plots métalliques, par exemple en cuivre, en contact avec tout ou partie des microcomposants afin de pouvoir mettre en contact des microcomposants d'une plaque avec ceux de l'autre plaque.

Les faces de collage des plaques peuvent en outre être traitées. Les traitements mis en œuvre pour la préparation de surface varient selon l'énergie de collage que l'on souhaite obtenir. Si l'on souhaite obtenir une énergie de collage standard, c'est-à-dire relativement faible, la surface peut être préparée en réalisant un polissage mécano-chimique suivi d'un nettoyage. Autrement, si l'on souhaite obtenir une énergie de collage importante entre les deux substrats, la préparation de la surface comprend un nettoyage de type RCA (à savoir la combinaison d'un bain SC1 ($NH_4OH$, $H_2O_2$, $H_2O$) adapté au retrait des particules et des hydrocarbures et d'un bain SC2 (HCl, $H_2O_2$, $H_2O$) adapté au retrait des contaminants métalliques), une activation de surface par plasma, un nettoyage supplémentaire suivi d'un brossage.

Le collage est réalisé de préférence sous une température contrôlée afin de réduire la différence de température entre les deux plaques.

La courbure de collage en forme de paraboloïde de révolution est calculée par les moyens de traitement de la machine de collage ou par des moyens analogues déportés de la machine de collage en utilisant les formules ou équations (2) à (7) décrites ci-avant.

L'imposition de la courbure de collage peut être également réalisée avec une machine de collage comprenant une membrane interposée entre la première plaque et le support de maintien de cette dernière, la membrane présentant une courbure correspondant à ladite courbure de collage prédéfinie en forme de paraboloïde de révolution, ou avec une machine de collage comprenant un support de maintien pour la première plaque présentant une courbure correspondant à ladite courbure de collage prédéfinie en forme de paraboloïde de révolution, le support de maintien pouvant notamment être déformable et piloté par la machine pour se conformer à la courbure de collage calculée précédemment par cette dernière ou par des moyens de calcul associés. La mise en contact de la deuxième plaque avec la première plaque et la libération de la deuxième plaque avant l'initiation de la propagation d'une onde de collage étant réalisées comme décrit ci-avant.

Grâce au procédé de collage, les deux plaques peuvent être collées ensemble avec des déformations homogènes n'entraînant que des défauts d'alignement qui peuvent être corrigés par des algorithmes lors de la formation de microcomposants supplémentaires après collage, induisant une réduction du désalignement de type overlay. On peut ainsi limiter les désalignements entre microcomposants à des valeurs négligeables de manière homogène sur toute la surface des plaques. Les microcomposants, même de tailles très réduites (par exemple < 1 $\mu$m), peuvent alors être formés facilement en alignement les uns avec les autres. Cela permet, par exemple, d'interconnecter entre eux les microcomposants, par l'intermédiaire de connections métalliques, en minimisant les risques de mauvaise interconnexion.

**Revendications**

1. Procédé de collage par adhésion moléculaire d'une première plaque (100) présentant une courbure propre avant collage ($K_1$) sur une deuxième plaque (200) présentant une courbure propre avant collage ($K_2$), au moins l'une (100) des deux plaques comportant au moins une série de microcomposants (110), ledit procédé comprenant au moins une étape de mise en contact des deux plaques (100, 200) de manière à initier la propagation d'une onde de collage entre les deux plaques,
   **caractérisé en ce qu'**il comprend, lors de l'étape de mise en contact :

   - le maintien de la première plaque (100) et de la deuxième plaque (200) en regard l'une de l'autre par respectivement un premier support de maintien (310) et un second support de maintien (320), ledit premier support imposant à la première plaque ladite courbure de collage prédéfinie (KB) en forme de paraboloïde de révolution qui est fonction des courbures propres avant collage (K1 ,K2) des première (100) et deuxième (200) plaques,
   - la mise en contact desdites plaques (100, 200) pour initier la propagation d'une onde de collage entre lesdites plaques,
   - la libération de la deuxième plaque (200) du second support de maintien (320) avant ou pendant la mise en contact avec la première plaque (100) de manière à ce que ladite deuxième plaque se conforme à la courbure de collage prédéfinie en forme de paraboloïde de révolution imposée à la première plaque, lors de la propagation de l'onde de collage.

2. Procédé selon la revendication 1, **caractérisé en ce**

**que**, avant le collage desdites plaques (100, 200), le procédé comprend les étapes suivantes:

- mesure de la courbure ($K_1$; $K_2$) de chaque plaque (100; 200) avant collage,
- calcul de la courbure de collage prédéfinie ($K_B$).

3. Procédé selon la revendication 1 ou 2, **caractérisé en ce que** seule la première plaque comporte au moins une série de microcomposants et **en ce que** la courbure de collage prédéfinie en forme de paraboloïde de révolution est calculée avec la formule suivante:

$$K_B = K_1 - ((K_2 - K_1)/6)$$

où $K_B$ est la courbure de collage prédéfinie en forme de paraboloïde de révolution, $K_1$ la courbure propre de la première plaque avant collage et $K_2$ la courbure propre de la deuxième plaque avant collage.

4. Procédé selon la revendication 1 ou 2, **caractérisé en ce que** chacune des deux plaques comporte au moins une série de microcomposants et **en ce que** la courbure de collage prédéfinie en forme de paraboloïde de révolution est calculée avec la formule suivante:

$$K_B = (K_1 + K_2)/2$$

où $K_B$ est la courbure de collage prédéfinie en forme de paraboloïde de révolution, $K_1$ la courbure propre de la première plaque avant collage et $K_2$ la courbure propre de la deuxième plaque avant collage.

5. Procédé selon l'une quelconque des revendications 1 à 4, **caractérisé en ce que** les plaques (100, 200) sont des plaquettes circulaires de silicium d'un diamètre de 300 mm.

6. Procédé selon l'une des revendications 1 à 5, **caractérisé en ce que** ladite courbure de collage prédéfinie en forme de paraboloïde de révolution ($K_B$) est imposée à la première plaque (100) par actionnement d'un vérin (312) monté sur le premier support de maintien.

7. Procédé selon la revendication 6, **caractérisé en ce que** ladite courbure de collage prédéfinie en forme de paraboloïde de révolution est imposée à la première plaque (100) par une membrane interposée entre la première plaque (100) et le premier support de maintien (310), ladite membrane présentant une courbure en forme de paraboloïde de révolution correspondant à ladite courbure de collage prédéfinie en forme de paraboloïde de révolution.

8. Procédé selon la revendication 6, **caractérisé en ce que** ladite courbure de collage prédéfinie est imposée à la première plaque (100) par le premier support de maintien (310), ledit premier support de maintien présentant une courbure correspondant à ladite courbure de collage prédéfinie en forme de paraboloïde de révolution.

9. Procédé selon l'une quelconque des revendications 1 à 8, **caractérisé en ce que** lesdites plaques (100, 200) comprennent chacune des microcomposants (110; 210) sur leur face de collage respective, au moins une partie des microcomposants (110) d'une (100) des plaques étant destinée à être alignée avec au moins une partie des microcomposants (210) de l'autre (200) plaque.

**Patentansprüche**

1. Verfahren zum molekularen Verkleben einer ersten Platte (100) mit einer vor der Verklebung eigenen Krümmung ($K_1$) auf eine zweite Platte (200) mit einer vor der Verklebung eigenen Krümmung($K_2$), wobei mindestens eine (100) der beiden Platten mindestens eine Reihe von Mikrokomponenten (110) aufweist, wobei das Verfahren mindestens einen Schritt des Zusammenführens der beiden Platten (100, 200) umfasst, so dass die Ausbreitung einer Verklebungswelle zwischen den beiden Platten ausgelöst wird,

**dadurch gekennzeichnet, dass** es während des Zusammenführens folgende Schritte umfasst:

- das Halten der ersten Platte (100) und der zweiten Platte (200) einander zugewandt durch eine erste Halterung (310) bzw. eine zweite Halterung (320), wobei die erste Halterung der ersten Platte die vordefinierte Verklebungskrümmung (KB) in Form eines Rotationsparaboloids vorgibt, die von den Eigenkrümmungen der ersten (100) und der zweiten Platte vor dem Verkleben ($K_1$, $K_2$) abhängt,
- das Zusammenführen der Platten (100, 200), um die Ausbreitung einer Verklebungswelle zwischen den Platten einzuleiten,
- das Lösen der zweiten Platte (200) von der zweiten Halterung (320) vor oder während der Zusammenführung mit der ersten Platte (100), so dass sich die zweite Platte während der Ausbreitung der Verklebungswelle an die von der ersten Platte vorgegebene, vordefinierte Verklebungskrümmung in Form eines Rotationsparaboloids anpasst.

2. Verfahren nach Anspruch 1, **dadurch gekennzeichnet, dass** das Verfahren vor dem Verkleben der Platten (100, 200) folgende Schritte umfasst:

- die Messung der Krümmung ($K_1$; $K_2$) jeder Platte (100; 200) vor dem Verkleben,
- die Berechnung der vordefinierten Verklebungskrümmung (KB) .

3. Verfahren nach Anspruch 1 oder 2, **dadurch gekennzeichnet, dass** nur die erste Platte mindestens eine Reihe von Mikrokomponenten aufweist und dass die vordefinierte Verklebungskrümmung in Form eines Rotationsparaboloids mit der folgenden Formel berechnet wird:

$$KB= K_1((K_2-K_1)/6),$$

wobei KB die vordefinierte Verklebungskrümmung in Form eines Rotationsparaboloids ist, $K_1$ die Eigenkrümmung der ersten Platte vor dem Verkleben und $K_2$ die Eigenkrümmung der zweiten Platte vor dem Verkleben.

4. Verfahren nach Anspruch 1 oder 2, **dadurch gekennzeichnet, dass** jede der beiden Platten mindestens eine Reihe von Mikrokomponenten aufweist und dass die vordefinierte Verklebungskrümmung in Form eines Rotationsparaboloids mit der folgenden Formel berechnet wird:

$$KB= (K_1+K_1)/2,$$

wobei $K_B$ die vordefinierte Verklebungskrümmung in Form eines Rotationsparaboloids ist, $K_1$ die Eigenkrümmung der ersten Platte vor dem Verkleben und $K_2$ die Eigenkrümmung der zweiten Platte vor dem Verkleben.

5. Verfahren nach einem der Ansprüche 1 bis 4, **dadurch gekennzeichnet, dass** die Platten (100, 200) kreisförmige Siliziumplatten mit einem Durchmesser von 300 mm sind.

6. Verfahren nach einem der Ansprüche 1 bis 5, **dadurch gekennzeichnet, dass** der ersten Platte (100) die vordefinierte Verklebungskrümmung in Form eines Rotationsparaboloids ($K_B$) durch Betätigen eines auf die erste Halterung montierten Zylinders vorgegeben wird.

7. Verfahren nach Anspruch 6, **dadurch gekennzeichnet, dass** der ersten Platte (100) die vordefinierte Verklebungskrümmung in Form eines Rotationsparaboloids durch eine zwischen der ersten Platte (100) und der ersten Halterung (310) angeordnete Membran vorgegeben wird, wobei die Membran eine Verklebungskrümmung in Form eines Rotationsparaboloids aufweist, die der vordefinierten Verklebungskrümmung in Form eines Rotationsparaboloids entspricht.

8. Verfahren nach Anspruch 6, **dadurch gekennzeichnet, dass** der ersten Platte (100) die vordefinierte Verklebungskrümmung durch die erste Halterung (310) vorgegeben ist, wobei die erste Halterung eine Krümmung aufweist, die der vordefinierten Verklebungskrümmung in Form eines Rotationsparaboloids entspricht.

9. Verfahren nach einem der Ansprüche 1 bis 8, **dadurch gekennzeichnet, dass** die Platten (100, 200) jeweils Mikrokomponenten (110; 210) auf ihrer jeweiligen Verklebungsfläche umfassen, wobei mindestens ein Teil der Mikrokomponenten (110) einer (100) der Platten dazu bestimmt ist, auf mindestens einem Teil der Mikrokomponenten (210) der anderen (200) Platte ausgerichtet zu werden.

**Claims**

1. A method for bonding by molecular adhesion a first plate (100) having an inherent curvature prior to bonding (K1) onto a second plate (200) having an inherent curvature prior to bonding (K2), at least one (100) of the two plates having at least one series of microcomponents (110), said method comprising at least one step of contacting the two plates (100, 200) so as to initiate the propagation of a bonding wave between the two plates,
**characterized in that** it comprises, during the contacting step:

  - holding the first plate (100) and the second plate (200) facing each other by a first holding support (310) and a second holding support (320) respectively, said first support imposing on the first plate said predefined bonding curvature (KB) in the form of a paraboloid of revolution which is based on the inherent curves prior to bonding (K1, K2) of the first (100) and second (200) plates,
  - contacting said plates (100, 200) to initiate the propagation of a bonding wave between said plates,
  - releasing the second plate (200) from the second holding support (320) before or during the step of contacting with the first plate (100) so that said second plate conforms to the predefined bonding curvature in the form of a paraboloid of revolution imposed on the first plate during the propagation of the adhesive wave.

2. A method according to claim 1, **characterized in that**, prior to bonding said plates (100, 200), the method comprises the following steps:

- measurement of the curvature (K1; K2) of each plate (100; 200) prior to bonding,
- calculation of the predefined bonding curvature (KB).

3. A method according to claim 1 or 2, **characterized in that** only the first plate has at least one series of microcomponents and **in that** the predefined bonding curvature in the form of a paraboloid of revolution is calculated using the following formula:

$$KB = K1((K2-K1)/6)$$

where KB is the predefined bonding curvature in the form of a paraboloid of revolution, K1 the inherent curvature of the first plate prior to bonding and K2 the inherent curvature of the second plate prior to bonding.

4. A method according to claim 1 or 2, **characterized in that** each of the two plates has at least one series of microcomponents and **in that** the predefined bonding curvature in the form of a paraboloid of revolution is calculated using the following formula:

$$KB = (K1+K1)/2$$

where KB is the predefined bonding curvature in the form of a paraboloid of revolution, K1 the inherent curvature of the first plate prior to bonding and K2 the inherent curvature of the second plate prior to bonding.

5. A method according to any one of claims 1 to 4, **characterized in that** the plates (100, 200) are circular silicon wafers with a diameter of 300mm.

6. A method according to one of claims 1 to 5, **characterized in that** said predefined bonding curvature in the form of a paraboloid of revolution (KB) is imposed on the first plate (100) by actuating a cylinder (312) mounted on the first holding support.

7. A method according to claim 6, **characterized in that** said predefined bonding curvature in the form of a paraboloid of revolution is imposed on the first plate (100) by a membrane interposed between the first plate (100) and the first holding support (310), said membrane having a bonding curvature in the form of a paraboloid of revolution corresponding to said predefined bonding curvature in the form of a paraboloid of revolution.

8. A method according to claim 6, **characterized in that** said predefined bonding curvature is imposed on the first plate (100) by the first holding support (310), said first holding support having a curvature corresponding to said predefined bonding curvature in the form of a paraboloid of revolution.

9. A method according to any one of claims 1 to 8, **characterized in that** said plates (100, 200) each comprise microcomponents (110; 210) on their respective bonding surfaces, at least a portion of the microcomponents (110) of one (100) of the plates being intended to be aligned with at least a portion of the microcomponents (210) of the other (200) plate.

**FIG.1**

**FIG.2**

**FIG.3**

$K_1 < 0$

$K_2 > 0$

50

60

**FIG.4A**

$K_B < 0$

50

60

**FIG.4B**

$K_F < 0$

50

60

**FIG.4C**

FIG.5A

FIG.5B

FIG.5C

FIG.5D

300

310

311

S6

312
313

313a

$K_{Fc} > 0$   110

100
200 } 350

321

320

**FIG.5E**

S7,S8

120

110

100a
360
200

**FIG.5F**

FORMATION OK OU GARDE SERIE
DE MICROCOMPOSANTS
SUR PREMIERE PLAQUE — S1

ALIGNEMENT DES PLAQUES — S2

COURBURE PREMIERE PLAQUE — S3

INITIATION PROPAGATION
D'ONDE DE COLLAGE — S4

LIBERATION DEUXIEME PLAQUE — S5

LIBERATION PREMIERE PLAQUE — S6

AMINCISSEMENT PREMIERE PLAQUE — S7

FORMATION DEUXIEME SERIE
DE MICROCOMPOSANTS SUR
PREMIERE PLAQUE AMINCIE — S8

# FIG.6

FIG.7A

FIG.7B

FIG.7C

700

710

711

RCb

712
713

**FIG.7D**

dt 713a

$K_B > 0$

500

510

500a

610

600

721

720

S40,S50

700

710

711

712
713

**FIG.7E**

dt 713a

$K_B > 0$

510

500

600

610

721

720

S60

S70

700

710

712
713

711

713a

$K_{Fc} > 0$

510

500
600 } 800

610

721

720

## FIG.7F

S80

510

500a
600 } 810

610

## FIG.7G

FORMATION PREMIERE SERIE DE MICROCOMPOSANTS SUR PLAQUE SUPERIEURE — S10

FORMATION DEUXIEME SERIE DE MICROCOMPOSANTS SUR PLAQUE INFERIEURE — S20

ALIGNEMENT DES PLAQUES — S30

COURBURE PLAQUE SUPERIEURE — S40

INITIATION PROPAGATION D'ONDE DE COLLAGE — S50

LIBERATION PLAQUE INFERIEURE — S60

LIBERATION PLAQUE SUPERIEURE — S70

AMINCISSEMENT PLAQUE SUPERIEURE — S80

# FIG.8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2010102943 A1

**Littérature non-brevet citée dans la description**

- **T. TURNER et al.** Mechanics of wafer bonding: Effect of clamping. *Journal of Applied Physics,* 01 Janvier 2004, vol. 95 (1